(19) Europäisches Patentamt
European Patent Office
Office européen des brevets

(11) Publication number: **0 629 919 A1**

(12) **EUROPEAN PATENT APPLICATION**

(21) Application number: **93201761.9**

(51) Int. Cl.⁵: **G03F 7/07**, G03C 8/06

(22) Date of filing: **18.06.93**

(43) Date of publication of application:
**21.12.94 Bulletin 94/51**

(84) Designated Contracting States:
**BE DE FR GB NL**

(71) Applicant: **AGFA-GEVAERT naamloze vennootschap**
**Septestraat 27**
**B-2640 Mortsel (BE)**

(72) Inventor: **Deprez, Lode c/o Agfa-Gevaert N.V.,**
**DIE 3800**
**Septestraat 27**
**B 2640 Mortsel (BE)**

(54) **A method for making by phototypesetting a lithographic printing plate according to the silver salt diffusion transfer process.**

(57) The present invention provides a method for making a lithographic printing plate according to the silver salt diffusion transfer process comprising the following steps:

- image-wise exposing with a high intensity-short time exposure an imaging element comprising on a support (i) a photosensitive layer comprising silver halide particles substantially free of built-in Iridium, said silver halide particles containing more than 95 mole% of silver chloride and having an average grain diameter of less than 0.27 µ and (ii) an image receiving layer containing physical development nuclei and
- developing said imaging element using an alkaline processing liquid in the presence of developing agent (s) and a meso-ionic compound.

EP 0 629 919 A1

1. Field of the invention.

The present invention relates to a method for obtaining a lithographic printing plate with a silver halide photographic material sensitive to high intensity-short time exposure according to the silver salt diffusion transfer process.

2. Background of the invention.

With recent rapid progress of information transmitting systems, silver halide photographic light sensitive materials have been increasingly required to have high sensitivity. Such systems are, for example, high speed phototypesetting systems according to which information output from an electronic computer is immediately displayed as letters or figures by a cathode ray tube and press facsimile systems for rapid transmission of newspaper originals to a remote place.

Todate on the market phototypesetters usually work with a He/Ne laser (632nm), laser diode (680nm) or LED (670nm or 780nm). Especially phototypesetters that operate with a He/Ne laser or LED are frequently employed, but also argon lasers (488 nm) are still in use.

For a photographic material to be suitable for use in phototypesetting applications it is required that the material is of high speed to so-called high intensity-short time exposure (flash exposure or scanning exposure), namely exposure for $10^{-4}$ second or less and yields images of high contrast and high resolving power.

Photographic phototypesetting materials include photographic films and papers used in a process for preparing a lithographic printing plate and silver salt diffusion transfer based (hereinafter called DTR-) lithographic printing plates disclosed in e.g. US-P-4,501,811 and US-P-4,784,933. With the latter materials a lithographic printing plate is immediately obtained without the need of a contact exposure or camera exposure.

A photographic DTR material preferably comprises a silver halide emulsion mainly consisting of silver chloride in order to obtain a sufficiently high rate of solution of the silver halide and a satisfactory gradation necessary for graphic purposes. Only a small amount of silver bromide and/or silver iodide usually not exceeding 5 mole % is present. However when using high intensity-short time exposure units the printing properties of a lithographic plate produced from DTR materials using conventional silver chloride emulsions are deteriorated e.g. more stain and lower printing endurance as disclosed in US-P-5,059,508.

So, in order to obtain DTR materials which can be used for high intensity-short time exposure and which will give good lithographic printing plates it is taught to use an emulsion with iridium built in as a dopant during the precipitation and/or the physical ripening of the silver halide and/or a higher silver bromide content as disclosed in US-P-4,621,041; 5,059,508; JN-03,274,055; 01,237,552; 02,284,147; 01,235957; 60,220,336 and 59,116,659.

However, the activity of the built-in iridium complex depends enormously on the conditions during its addition. It is known that the initial ligands of commercially available iridium complexes can exchange with other ligands (water, hydroxyl ions, etc.). This exchange reaction happens whenever the halogen complex is dissolved and the rate is very much depending on the temperature, the acidity, the amount of free silver ions etc. of the medium and is therefore largely unpredictable.

If an emulsion with a higher silver bromide content is to be used a core-shell emulsion has to be prepared.

However the lithographic plates produced from a DTR material containing the above mentioned emulsions lack reproducibility and are prone to pin holes (phenomenon in the printing plate that causes in the copies obtained from such plate places of lower density in an area that should have an homogeneous density).

3. Summary of the invention.

It is an object of the present invention to provide a method for obtaining a lithographic plate with good printing properties and improved for sensitivity to pin holes from a silver halide photographic material sensitive to high intensity-short time exposure according to the DTR-process.

Further objects of the present invention will become clear from the description hereinafter.

According to the present invention there is provided a method for making a lithographic printing plate according to the silver salt diffusion transfer process comprising the following steps:

- image-wise exposing with a high intensity-short time exposure an imaging element comprising on a support (i) a photosensitive layer comprising silver halide particles substantially free of built-in Iridium,

said silver halide particles containing more than 95 mole% of silver chloride and having an average grain diameter of less than 0.27 μ and (ii) an image receiving layer containing physical development nuclei and

- developing said imaging element using an alkaline processing liquid in the presence of developing agent(s) and a meso-ionic compound.

4. Detailed description of the present invention.

According to the present invention it has been found that a lithographic plate with good printing properties is obtained with a silver halide photographic material sensitive to high intensity-short time exposure according to the DTR-process in the presence of meso-ionic compounds when the photosensitive layer comprises silver halide particles substantially free of built-in Iridium, said silver halide particles containing more than 95 mole% of silverchloride and having an average grain diameter of less than 0.27 μ.

Although the size of the silver halide grains above is expressed by a diameter this does not imply that the silver halide grains are necessarily spherical. By diameter is meant the diameter of a sphere having an equivalent volume so that the size of silver halide grains of a variety of shapes can be characterized by the same parameter.

By the wording "substantially free of built-in Iridium" is meant an emulsion containing less than $10^{-8}$ mole, preferably less than $10^{-10}$ mole built-in Iridium per mole of $AgNO_3$. Iridium is built into the silver halide particles by adding Iridium containing compounds during the precipitation or physical ripening stage. Iridium may be added in an substantial amount after the end of the physical ripening because from that moment on, Iridium is not longer built in as a dopant in the emulsion so that its influence is strongly decreased, having only a stabilizing effect on the latent image stability.

The photosensitive layer used in accordance with the present invention can consist of any silver halide emulsion comprising a hydrophilic colloid binder, at least one of the photosensitive silver halide emulsions being as disclosed in the present invention.

The photographic silver halide emulsion(s) used in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

The photographic silver halide emulsions used according to the present invention can be prepared by mixing the halide and silver solutions in partially or fully controlled conditions of temperature, concentrations, sequence of addition, and rates of addition. The silver halide can be precipitated according to the single-jet method or the double-jet method.

The silver halide particles of the photographic emulsions used according to the present invention may have a regular crystalline form such as a cubic or octahedral form or they may have a transition form. They may also have an irregular crystalline form such as a spherical form or a tabular form, or may otherwise have a composite crystal form comprising a mixture of said regular and irregular crystalline forms.

According to the present invention the emulsion or emulsions preferably consist principally of silver chloride. When silver chlorobromide emulsions are used they preferably belong to the core/shell type well known to those skilled in the art in the sense that substantially all the bromide is concentrated in the core. This core contains preferably 10 to 40 % of the total silver halide precipitated, while the shell consists preferably of 60 to 90 % of the total silver halide precipitated. The silver halide may also contain small amounts of iodide e.g. upto 3%.

Surface image emulsions may be used or internal image emulsions may be used such as those described in US-A 2,592,250, 3,206,313, and 3,447,927. Two or more types of silver halide emulsions that have been prepared differently can be mixed for forming a photographic emulsion layer for use in accordance with the present invention.

The average size of the silver halide grains may range from 0.10 to 0.70 μm , preferably from 0.20 to 0.45 μm.

The size distribution of the silver halide particles to be used according to the present invention can be homodisperse or heterodisperse. A homodisperse size distribution is obtained when 95% of the grains have a size that does not deviate more than 30% from the average grain size.

During the precipitation stage rhodium containing compounds can be added. The concentration of these added compounds ranges from $10^{-8}$ to $10^{-3}$ mole per mole of $AgNO_3$, preferably between $10^{-7}$ and $10^{-6}$ per mole of $AgNO_3$. This results in the building in in the silver halide crystal lattice of minor amounts of rhodium, so-called rhodium dopants. Rhodium and/or Iridium containing compounds can also be added

after the physical ripening of the emulsions but its effects are then strongly decreased. As known to those skilled in the art numerous scientific and patent publications disclose the addition of iridium or rhodium containing compounds or compounds containing other elements of Group VIII of the Periodic System during emulsion preparation.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The emulsions of the DTR-element can be spectrally sensitized for exposure by laser light e.g. helium-neon laser light, and semiconductor laser light. Dyes that can be used for adjusting the photosensitivity to laser light have been described in i.a. JA-Pi 62-284344, 62-284345, 62-141561, 62-103649, 62-139555, 62-105147, 62-105148, 62-075638, 62-062353, 62-062354, 62-062355, 62-157027, 62-157028, 62-113148, 61-203446, 62-003250, 60-061752, 55-070834, 51-115821, 51-115822, 51-106422, 51-106423, 51-106425; DE-A-3,826,700; US-P-4,501,811, 4,725,532, 4,784,933; US Serial No. 07/986,071; GB-P-1,467,638; EP-A 100,654, and in documents cited therein.

In case of exposure by a red light emitting source, e.g. a LED or a HeNe laser a red sensitizing dye is used as disclosed in e.g. U.S. Serial No. 07/978,084. In case of exposure by a semiconductor laser special spectral sensitizing dyes suited for the near infra-red are required as disclosed in e.g. U.S. Serial No. 07/978,085. To enhance the sensitivity in the near infra-red region use can be made of so-called supersensitizers in combination with infrared sensitizing dyes. Suitable supersensitizers are described in Research Disclosure Vol 289, May 1988, item 28952. A preferred red sensitizing dye, infra-red sensitizing dye and supersensitizer are disclosed in US. Serial No. 07/986,071.

The spectral sensitizers can be added to the photographic emulsions in the form of an aqueous solution, a solution in an organic solvent or in the form of a dispersion.

The silver halide emulsions may contain the usual stabilizers e.g. homopolar or salt-like compounds of mercury with aromatic or heterocyclic rings such as mercaptotriazoles, simple mercury salts, sulphonium mercury double salts and other mercury compounds. Other suitable stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives, and benzotriazole. Preferred compounds are mercapto substituted pyrimidine derivatives as disclosed in US-P 3,692,527.

The silver halide emulsions may contain pH controlling ingredients. Preferably the emulsion layer is coated at a pH value below the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787, DE-P 2,453,217.

In an especially preferred embodiment the emulsion layer contains a compound which comprises in its molecular structure a group capable of adsorbing to silver halide and a group capable of reducing silver halide. Compounds of this kind have been disclosed in EP-A-449340. In this way a combination of a stabilizing and a development activating function in one compound is achieved.

More details about the composition, preparation and coating of silver halide emulsions can be found in e.g. Product Licensing Index, Vol. 92, December 1971, publication 9232, p. 107-109.

Preferred meso-ionic compounds for use in connection with the invention are those represented by formula (I):

$$M + A^{\ominus} \quad (I)$$

wherein M represents a 5- or 6-membered heterocyclic ring composed of at least one member selected from the group consisting of a carbon atom, an oxygen atom, a nitrogen atom, a sulfur atom and a selenium atom; and $A^{\ominus}$ represents $-O-^{\ominus}$, $-S^{\ominus}$ or $-N^{\ominus}-R$, wherein R represents an alkyl group (preferably having 1 to 6 carbon atoms), a cycloalkyl group (preferably having 3 to 6 carbon atoms), an alkenyl group (preferably having 2 to 6 carbon atoms) an alkynyl group (preferably having 2 to 6 carbon atoms), an aralkyl group, an aryl group (preferably having 6 to 12 carbon atoms), or a heterocyclic group (preferably having 1 to 6

carbon atoms).

In formula (I), examples of the 5-membered heterocyclic ring as represented by M include an imidazolium ring, a pyrazolium ring, an oxazolium ring, an isoxazolium ring, a thiazolium ring, an isothiazolium ring, a 1,3-dithiol ring, a 1,3,4- or 1,2,3 oxadiazolium ring, a 1,3,2-oxathiazolium ring, a 1,2,3-triazolium ring, a 1,3,4-triazolium ring, a 1,3,4-, 1,2,3- or 1,2,4-thiadiazolium ring, a 1,2,3,4-oxatriazolium ring, a 1,2,3,4-tetrazolium ring and a 1,2,3,4-thiatriazolium ring.

Preferred meso-ionic compounds for use in accordance with the present invention are triazolium thiolates and more preferably 1,2,4-triazolium-3-thiolates and most preferably those that correspond to the following formula:

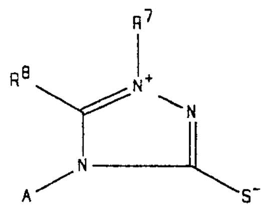

wherein $R^7$ and $R^8$ each independently represents a substituted or unsubstituted alkyl group, a substituted or unsubstituted alkenyl group, a substituted or unsubstituted cycloalkyl group, a substituted or unsubstituted aralkyl group, a substituted or unsubstituted aryl group or a substituted or unsubstituted heterocyclic group, A represents a substituted or unsubstituted alkyl group, a substituted or unsubstituted alkenyl group, a substituted or unsubstituted cycloalkyl group, a substituted or unsubstituted aralkyl group, a substituted or unsubstituted aryl group, a substituted or unsubstituted heterocyclic group or $-NR^9R^{10}$ and $R^9$ and $R^{10}$ each independently represents hydrogen, a substituted or unsubstituted alkyl group, a substituted or unsubstituted aryl group or $R^7$ and $R^8$ or $R^8$ and A or $R^9$ and $R^{10}$ represent the necessary atoms to form together with the atoms to wich they are attached a 5- or 6-membered ring.

Specific examples of 1,2,4-triazolium-3-thiolates suitable for use in accordance with the present invention are shown in table 1.

Table 1

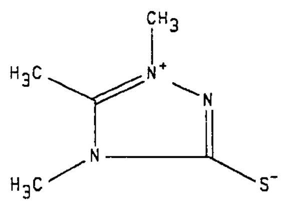

(1)

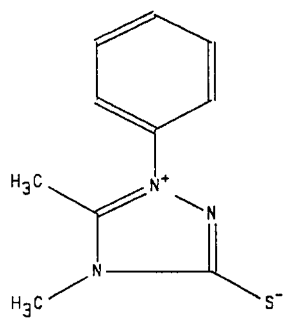

(2)

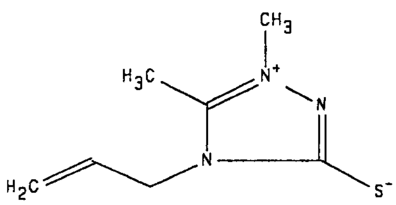

(3)

(4)

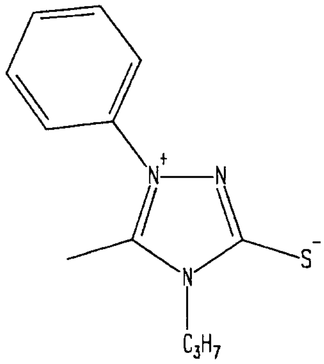

(5)

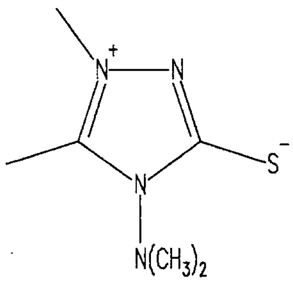

(6)

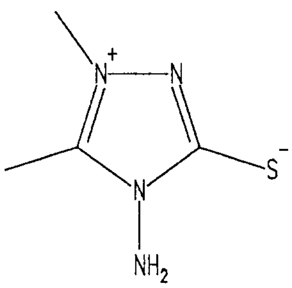

(7)

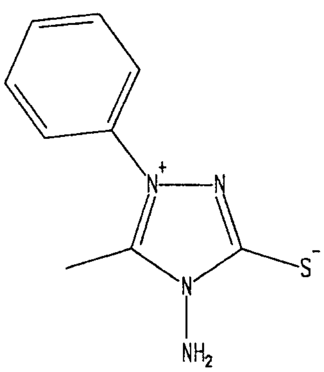

According to the preferred embodiment of the present invention at least part and most preferably all of the meso-ionic compound is preferably present in the alkaline processing liquid used for developing the image-wise exposed imaging element. Preferably the amount of meso-ionic compound in the alkaline processing liquid is between 0.1 mmol/l and 50 mmol/l and more preferably between 0.1 mmol/l and 25 mmol/l and most preferably between 0.5 mmol/l and 10 mmol/l.

However the meso-ionic compound may be incorporated in one or more layers comprised on the support of the imaging element. This offers the advantage of replenishment of said meso-ionic compound in the alkaline processing liquid. Preferably the meso-ionic compound is incorporated in a layer of the imaging element that does not contain silver halide such as e.g. in a backing layer, in the image receiving layer, a

subbing layer etc.. The meso-ionic compound is preferably contained in the imaging element in a total amount between 0.1 and 10mmol/$m^2$, more preferably between 0.1 and 5mmol/$m^2$ and most preferably between 0.5 and 1.5mmol/$m^2$.

According to the present invention the alkaline processing liquid used for developing the imaging element preferably contains a further silver halide solvent although this is no absolute requirement since meso-ionic compounds can be used as the sole silver halide solvent. Preferably the silver halide solvent is used in an amount between 0.05% by weight and 10% by weight and more preferably between 0.05% by weight and 7% by weight. Suitable silver halide solvents for use in connection with the present invention are e.g. 2-mercaptobenzoic acid, cyclic imides, oxazolidones, thiocyanates, thiosulfates and the compounds disclosed in US Serial No. 07/810,146. Further silver halide solvents that can be used in connection with the present invention are alkanolamines. Alkanolamines that are suitable for use in accordance with the present invention may be of the tertiary, secundary or primary type. Examples of alkanolamines that may be used in connection with the present invention correspond to the following formula:

$C_1H_{21}$-X
N-$C_mH_{2m}$-X'
$C_nH_{2n}$-OH

wherein X and X' independently represent hydrogen, a hydroxyl group or an amino group, 1 and m represent 0 or integers of 1 or more and n represents an integer of 1 or more. Preferably used alkanolamines are e.g. N-(2-aminoethyl)ethanolamine, diethanolamine, N-methylethanolamine, triethanolamine, N-ethyldiethanolamine, diisopropanolamine, ethanolamine, 4-aminobutanol, N,N-dimethylethanolamine, 3-aminopropanol, N,N-ethyl-2,2'-iminodiethanol etc. or mixtures thereof.

According to the present invention the alkanolamines are preferably present in the alkaline processing liquid in a concentration preferably between 0.05% and 10% by weight. However part or all of the alkanolamine can be present in one or more layers of the imaging element.

Especially good results are obtained when a meso-ionio compound, preferably a triazolium thiolate, is used in combination with a thioether as silver halide solvent. The best results are obtained when a combination of a meso-ionic compound, a thioether and/or an alkanolamine are used as silver halide solvents. Preferably used thioethers correspond to the following general formula:

$Z-(R^1-S)_t-R^2-S-R^3-Y$

wherein Z and Y each independently represents hydrogen, an alkyl group, an amino group, an ammonium group, a hydroxyl, a sulfo group, a carboxyl, an aminocarbonyl or an aminosulfonyl, $R^1$, $R^2$ and $R^3$ each independently represents an alkylene that may be substituted and optionally contain a oxygen bridge and t represents an integer from 0 to 10.

Examples of thioether compounds corresponding to the above formula are disclosed in e.g. US-P-4,960,683 and US-P-5,200,294 and specific examples are listed in table 2

Table 2

| | |
|---|---|
| $(HO-CH_2-CH_2)_2S$ | 1 |
| $HO-CH_2-CH_2-S-CH_2-S-CH_2-CH_2-OH$ | 2 |
| $HO-CH_2-CH_2-S-(CH_2)_2-S-CH_2-CH_2-OH$ | 3 |
| $HO-CH_2-CH_2-S-(CH_2)_3-S-CH_2-CH_2-OH$ | 4 |
| $HO-CH_2-CH_2-S-(CH_2)_4-S-CH_2-CH_2-OH$ | 5 |
| $C_2H_5-S-CH_2-CH_2-S-CH_2-CHOH-CH_2-OH$ | 6 |

$(HOCH_2-CH_2-S-CH_2-CH_2)_2O$ 7

$HO-CH_2-CH_2-S-CH_2-CH_2-N(CH_3)_2$ 8

$(HO-CH_2-CHOH-CH_2-S-CH_2)_2$ 9

$HOOC-CH_2-S-CH_2-S-CH_2-COOH$ 10

$HOOC-CH_2-S-(CH_2)_2-S-CH_2-COOH$ 11

$HOOC-CH_2-S-(CH_2)_3-S-CH_2-COOH$ 12

$HOOC-(CH_2)_2-S-CH_2-S-(CH_2)_2-COOH$ 13

$HOOC-(CH_2)_2-S-(CH_2)_2-S-(CH_2)_2-COOH$ 14

$HOOC-(CH_2)_2-S-(CH_2)_3-S-(CH_2)_2-COOH$ 15

$CH_3-S-CH_2-CH_2-CH-COOH$ 16
$\qquad\qquad\qquad NH_2$

According to the present invention the alkaline processing liquid preferably also contains hydrophobizing agents for improving the hydrophobicity of the silver image obtained in the image receiving layer. The hydrophobizing agents used in connection with the present invention are compounds that are capable of reacting with silver or silver ions and that are hydrophobic i.e. insoluble in water or only slightly soluble in water. Generally these compounds contain a mercapto group or thiolate group and one or more hydrophobic substituents e.g. an alkyl group containing at least 3 carbon atoms. Examples of hydrophobizing agents for use in accordance with the present invention are e.g. those described in US-P-3,776,728, and US-P-4,563,410. Preferred compounds correspond to one of the following formulas:

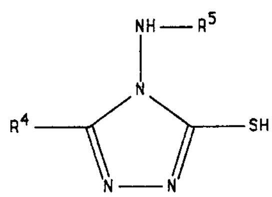

(II)

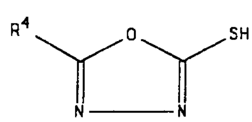

(III)

wherein $R^5$ represents hydrogen or an acyl group, $R^4$ represents alkyl, aryl or aralkyl. More preferably used compounds are compounds according to one of the above formulas wherein $R^4$ represents an alkyl containing 3 to 16 C-atoms.

Particularly preferred hydrophobizing agents in connection with the present invention are long chain (at least 5 carbon atoms) alkyl substituted mercaptotetrazoles, more in particular those according to the following formula (IV):

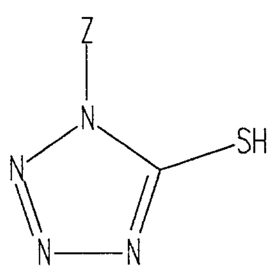

(IV)

wherein Z represents a substituted or unsubstituted alkyl, a substituted or unsubstituted aryl, a substituted or unsubstituted aralkyl, a substituted or unsubstituted alkylaryl, a substituted or unsubstituted alkenyl, a substituted or unsubstituted alkynyl or a heterocyclic ring.

Specific examples of hydrophobizing agents according to formula (IV) are listed in table 3.

Table 3

| compound no. | Z in formula (II) |
|---|---|
| 1 | $CH_2CONH\text{-}n.C_6H_{13}$ |
| 2 | $CH_2CON(n.C_4H_9)_2$ |
| 3 | $C_6H_{13}$ |

The hydrophobizing agents can be used alone or in combination with each other. A preferred combination is one containing a hydrophobizing agent according to the formulas (II) or (III) with a hydrophobizing agent according to the formula (IV).

According to the present invention the hydrophobizing agents are contained in the alkaline processing liquid in an amount of at least 0.1g/l, more preferably at least 0.2g/l and most preferably at least 0.3g/l. The maximum amount of hydrophobizing agents will be determined by the type of hydrophobizing agent, type and amount of silver halide solvents etc.. Typically the concentration of hydrophobizing agent is preferably not more than 1.5g/l and more preferably not more than 1g/l.

The alkaline processing liquid used in accordance with the present invention preferably has a pH between 9 and 14 and more preferably between 10 and 13. Said pH may be established by an organic or inorganic alkaline substance or a combination thereof. Suitable inorganic alkaline substances are e.g. potassium or sodium hydroxide, carbonate, phosphate etc.. Suitable organic alkaline substances are e.g. alkanolamines. In the latter case the alkanolamines will provide or help maintain the pH and serve as a silver halide complexing agent.

The alkaline processing liquid may also contain the developing agent(s) used in accordance with the present invention. In this case the alkaline processing liquid is called a developer. On the other hand some or all of the developing agent(s) may be present in one or more layers of the imaging element. When all of the developing agents are contained in the imaging element the alkaline processing liquid is called an activator or activating liquid.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. Preferred phenidone type developing agents, particularly when they are incorporated into the photographic material are phenidones of which the aqueous solubility is increased by a hydrophilic substituent such as e.g. hydroxy, amino, carboxylic acid group, sulphonic acid group etc. Examples of phenidones subsituted with one or more hydrophilic groups are e.g. 1-phenyl-4,4-dimethyl-2-hydroxy-3-pyrazolidone, 1-(4-carboxyphenyl)-4,4-dimethyl-3-pyrazolidone etc.. However other developing agents can be used.

At least the auxiliary developing agents are preferably incorporated into the photographic material. The auxiliary developing agent is preferably incorporated in the photographic material, preferably in the silver halide emulsion layer of the photographic material, in an amount of less than 150mg/g of silver halide expressed as $AgNO_3$, more preferably in an amount of less than 100mg/g of silver halide expressed as $AgNO_3$.

The alkaline processing liquid preferably also contains a preserving agent having antioxidation activity e.g. sulphite ions provided e.g. by sodium or potassium sulphite. For example, the aqueous alkaline solution comprises sodium sulphite in an amount ranging from 0.15 to 1.0 mol/l. Further may be present a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners.

Development acceleration can be accomplished with the aid of various compounds added to the alkaline processing liquid and/or one or more layers of the photographic element, preferably polyalkylene derivatives having a molecular weight of at least 400 such as those described in e.g. US-P-3,038,805;

4,038,075; 4,292,400; 4,975,354.

According to one embodiment of the present invention for obtaining a lithographic printing plate an imaging element comprising in the order given (i) a support, (ii) a photosensitive layer comprising silver halide particles in accordance with the present invention and (iii) an image receiving layer is image-wise or information-wise exposed and subsequently developed in the presence of a meso-ionic compound using an alkaline processing liquid e.g. as described above.

The development step is preferably followed by a neutralization of the surface of the imaged element by guiding the element through a neutralization liquid having a pH between 4 and 7. The neutralization liquid preferably contains a buffer e.g. a phosphate buffer, a citrate buffer or mixture thereof. The neutralization solution can further contain bactericides, e.g. phenol, thymol or 5-bromo-5-nitro-1,3-dioxan as described in EP 0,150,517. The liquid can also contain substances which influence the hydrophobic / hydrophilic balance of the printing plate obtained after processing of the DTR element, e.g. silica. Further the neutralization solution can contain wetting agents, preferably compounds containing perfluorinated alkyl groups. By adding an inorganic fluoride e.g. NaF in amounts of 80mg/l or less to the neutralization solution toning of the printing plate can be reduced or avoided. Instead of or in combination with the inorganic fluoride a cationic polymer or a polymer containing amino groups can be added to the neutralization solution for reducing toning of the plate. Specific examples of polymers containing amino groups are e.g. a poly(N-3-(2-aminoethyl)-aminopropylsiloxane) or a dextran comprising a group containing an amino group e.g. Dormacid that is commercially available from Pfeifer & Langen and is the commercial name for a dextran containing diethylaminoethyl groups. These polymers are preferably added to the neutralization solution in amounts of 0.01% to 5% and more preferably in amounts of 0.05% to 1% and most preferably in amounts between 0.05% and 0.5%.

According to the present invention the imaging element can be information-wise exposed in an apparatus according to its particular application, e.g. a LED or a laser containing device.

The imaging element in connection with the present invention for preparing a lithographic printing plate essentially comprises in the order given (i) a support, (ii) a photosensitive layer comprising silver halide particles in accordance with the present invention and (iii) an image receiving layer. As described above one of the layers contained on the support of the imaging element may contain a 1,2,4-triazolium-3-thiolate in accordance with the present invention.

Supports suitable for use in accordance with the present invention may be opaque or transparent, e.g. a paper support or resin support. When a paper support is used preference is given to one coated at one or both sides with an Alpha-olefin polymer, e.g. a polyethylene layer which optionally contains an anti-halation dye or pigment. It is also possible to use an organic resin support e.g. cellulose nitrate film, cellulose acetate film, poly(vinyl acetal) film, polystyrene film, poly(ethylene terephthalate) film, polycarbonate film, polyvinylchloride film or poly-Alpha-olefin films such as polyethylene or polypropylene film. The thickness of such organic resin film is preferably comprised between 0.07 and 0.35 mm. These organic resin supports are preferably coated with a hydrophilic adhesion layer which can contain water insoluble particles such as silica or titanium dioxide. Metal supports e.g. aluminium may also be used in accordance with the present invention.

Suitable physical development nuclei for use in the receiving layer in accordance with the present invention are sulphides of heavy metals e.g. sulphides of antimony, bismuth, cadmium, cobalt, lead, nickel, palladium, platinum, silver, and zinc. Preferably used are PdS, $Ag_2S$ or AgNiS nuclei. Other suitable development nuclei are salts such as e.g. selenides, polyselenides, polysulphides, mercaptans, and tin (II) halides. Heavy metals, preferably silver, gold, platinum, palladium, and mercury can be used in colloidal form.

The image receiving layer containing physical development nuclei used in accordance with the present invention is preferably free of hydrophilic binder but may comprise small amounts upto 30% by weight of the total weight of said layer of a hydrophilic colloid e.g. polyvinyl alcohol to improve the hydrophilicity of the surface.

The amount of nuclei used in the image receiving layer is preferably between 0.02 $mg/m^2$ and 10 $mg/m^2$.

In addition to the above described emulsion layer and image receiving layer other hydrophilic colloid layers in water permeable relationship with these layers may be present. For example it is especially advantageous to include a base-layer between the support and the photosensitive silver halide emulsion layer. In a preferred embodiment of the present invention said base-layer serves as an antihalation layer. This layer can therefore contain the same light-absorbing dyes as described above for the emulsion layer ; as alternative finely divided carbon black can be used for the same antihalation purposes as described in US-P-2,327,828. On the other hand, in order to gain sensitivity, light reflecting pigments, e.g. titaniumdioxide can be present. Further this layer can contain hardening agents, matting agents, e.g. silica particles, and wetting agents. At least part of these matting agents and/or light reflection pigments may also be present in the silver halide emulsion layer the most part however preferably being present in said base-layer. As a further alternative the light reflecting pigments may be present in a separate layer provided between the antihalation layer and the photosensitive silver halide emulsion layer.

In a preferred embodiment in connection with the present invention a backing layer is provided at the non-light sensitive side of the support. This layer which can serve as anti-curl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a double layer pack.

The hydrophilic layers usually contain gelatin as hydrophilic colloid binder. Mixtures of different gelatins with different viscosities can be used to adjust the rheological properties of the layer. Like the emulsion layer the other hydrophilic layers are coated preferably at a pH value below the isoelectric point of the gelatin. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc..

The hydrophilic layers of the photographic element, especially when the binder used is gelatin, can be hardened with appropriate hardening agents such as those of the epoxide type, those of the ethylenimine type, those of the vinylsulfone type e.g. 1,3-vinylsulphonyl-2-propanol, methylenebis (sulfonylethylene), chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

Preferably used hardening agents are of the aldehyde type. The hardening agents can be used in wide concentration range but are preferably used in an amount of 4% to 7% of the hydrophilic colloid. Different amounts of hardener can be used in the different layers of the imaging element or the hardening of one layer may be adjusted by the diffusion of a hardener from another layer.

The imaging element used according to the present invention may further comprise various kinds of surface-active agents in the photographic emulsion layer or in at least one other hydrophilic colloid layer. Suitable surface-active agents include non-ionic agents such as saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Preferably compounds containing perfluorinated alkyl groups are used. Such surface-active agents can be used for various purposes e.g. as coating aids, as compounds preventing electric charges, as compounds improving slidability, as compounds facilitating dispersive emulsification and as compounds preventing or reducing adhesion.

The photographic material of the present invention may further comprise various other additives such as e.g. compounds improving the dimensional stability of the photographic element, UV-absorbers, spacing agents and plasticizers.

Suitable additives for improving the dimensional stability of the photographic element are e.g. dispersions of a water-soluble or hardly soluble synthetic polymer e.g. polymers of alkyl (meth)acrylates, alkoxy-(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth) acrylates, sulphoalkyl (meth)acrylates, and styrene sulphonic acids.

According to another embodiment of the present invention a lithographic printing plate can be obtained by means of the DTR-process using an imaging element comprising in the order given (i) a grained and anodized aluminium support, (ii) an optional layer of physical development nuclei and (iii) a photosensitive layer comprising silver halide particles in accordance with the present invention. The imaging element of the present embodiment may be imaged using a scanning exposure as described above followed by a

development step in the presence of development agent(s) and silver halide solvent(s) according to the invention so that a silver image is formed in the physical development nuclei layer or directly on the aluminium support. Subsequently the silver halide emulsion layer and any other optional hydrophilic layers are removed by rinsing the imaged element with water so that the silver image is exposed. Finally the hydrophobic character of the silver image is preferably improved using a finishing liquid comprising hydrophobizing agents as described above.

The present invention will now be illustrated by the following example without however limiting it thereto. All parts are by weight unless otherwise specified

EXAMPLE 1

Preparation of the silver halide emulsion coating solution.

A gelatin silver halide emulsion I was prepared using the double jet precipitation by slowly mixing whilst stirring an aqueous solution of $AgNO_3$ having a concentration of 2 mole/l, and an aqueous solution having a concentration of 1.7 mole/l of NaCl and 0.48 mole/l of KBr. Before the precipitation $5*10^{-4}$ mole/l of sodium hexachlororhodaat was added to the alkali halide solution. In a second part of the precipitation an aqueous solution of $AgNO_3$ having a concentration of 1 mole/l was slowly mixed with a aqueous solution of NaCl at a concentration of 1.3 mole/l.

The temperature during the silver halide formation was 55 °C. The obtained core-shell emulsion was cooled, flocculated and washed. Gelatin was added in an amount sufficient to reach a ratio of 2/3 by weight of gelatin to silver halide, expressed as equivalent amount of silver nitrate.

A gelatin silver halide emulsion II was prepared using the double jet precipitation by mixing whilst stirring an aqueous solution of $AgNO_3$ having a concentration of 3 mole/l, and an aqueous solution having a concentration of 3 mole/l of NaCl and 0.054 mole/l of KBr. Before the precipitation $5*10^{-4}$ mole/l of sodium hexachlororhodaat was added to the alkali halide solution.

The temperature during the silver halide formation was 50 °C. The obtained emulsion was cooled, flocculated and washed. Gelatin was added in an amount sufficient to reach a ratio of 2/3 by weight of gelatin to silver halide, expressed as equivalent amount of silver nitrate.

Gelatin silver halide emulsions III was prepared as gelatin silver halide emulsions II but before the precipitation $0.6*10^{-6}$ mole/l of sodium hexachloroiridaat was supplementary added to the alkali halide solution.

Subsequently a chemical ripening of the emulsions I to III was carried out in a conventional way, known to those skilled in the art, by first adding 0.02 mole KI per mole $AgNO_3$ and subsequently thiosulphate and gold salts.

The emulsions I to III were red sensitised using a red sensitizing dye according to the following procedure : first calcium nitrate was added in an amount of $8.2*10^{-2}$ mole per mole of $AgNO_3$ and then the red sensitizing dye was added.

Finally the emulsions I to III were stabilized by 1-phenyl-5-mercapto-tetrazole.

The important characteristics of the emulsions I to III are summarized in table 3.

Table 3

| Characteristics of the emulsions I to VI | | | | |
|---|---|---|---|---|
| Emulsion | Mole% $Br^-$ | Mole% $I^-$ | Mole% $Ir^-$ | Aver. size |
| I | 15.8 | 0.2 | 0 | 0.38 |
| II | 1.8 | 0.2 | 0 | 0.24 |
| III | 1.8 | 0.2 | 0.2 | 0.24 |

A base layer coating solution was prepared having the following composition:

| | |
|---|---|
| gelatin | 5.5% |
| carbon black | 0.76% |
| silica particles (5µm) | 1.6% |

Preparation of the imaging elements **1** to **3**.

The emulsion coating solutions I to III were respectively coated simultaneously with the base layer coating solution by means of the cascade coating technique to a polyethylene terephthalate support provided with a pack of two backing layers such that the base layer coating was coated directly to the side of the support opposite to the side containing said backing layers. The emulsion layers were coated such that the silver halide coverage expressed as $AgNO_3$ was 1.5g/m$^2$ and the gelatin content was 1.5g/m$^2$. The emulsion layers further contained 0.15g/m$^2$ of 1-phenyl-4,4'-dimethyl-3-pyrazolidone and 0.25g/m$^2$ of hydroquinone. The base layer was coated such that the amount of gelatin in the coated layer was 3g/m$^2$.

The layer nearest to the support of the backing layer pack contained 0.3 g/m$^2$ of gelatin and 0.5 g/m$^2$ of the antistatic agent co (tetraallyloxyethane / methacrylate / acrylic acid-K-salt) polymer. The second backing layer contained 4 g/m$^2$ of gelatin, 0.15 g/m$^2$ of a matting agent consisting of transparent spherical polymeric beads of 3 micron average diameter according to EP-A-080,225, 0.05 g/m$^2$ of hardening agent triacrylformal and 0.021 g/m$^2$ of wetting agent $F_{15}C_7$-$COONH_4$.

The thus obtained elements were dried and subjected to a temperature of 40 °C for 5 days and then the emulsion layers were overcoated with a layer containing PdS as physical development nuclei, hydroquinone at 0.4g/m$^2$ and formaldehyde at 100mg/m$^2$.

The following processing solutions were prepared :

| Activator | A | B |
|---|---|---|
| sodium hydroxide (g) | 30 | 30 |
| sodium sulphite anh. (g) | 35 | 35 |
| potassium thiocyanate (g) | 20 | 0 |
| compound 3 of table 1 (mg) | 0 | 1100 |
| 2-Aminoethyl-aminoethanol (ml) | 0 | 30 |
| 2-mercapto-5-n.heptyl-oxa-3,4-diazole (mg) | 150 | 150 |
| water to make | 1 l | 1 l |

| Neutralization solution | |
|---|---|
| citric acid | 10 g |
| sodium citrate | 35 g |
| sodium sulphite anh. | 5 g |
| phenol | 50 mg |
| water to make | 1 l |

| Dampening solution | |
|---|---|
| water | 880 ml |
| citric acid | 6 g |
| boric acid | 8.4 g |
| sodium sulphate anh. | 25 g |
| ethyleneglycol | 100 g |
| colloidal silica | 28 g |

The above described imaging elements **1** to **3** were image-wise exposed in a HeNe laser image setter and processed with one of the above described activators for 10 seconds at 30 °C, subsequently neutralized at 25 °C with the neutralization solution described above and dried.

The printing plates thus prepared were mounted on the same offset printing machine (Heidelberg GTO-46) and were printed under identical conditions. The above mentioned dampening solution was used at a 5 % concentration for fountain solution, and K+E 125 ink was used. A compressible rubber blanket was used.

The results are summed up in the following table.

The lithographic properties printing endurance, staining and sensitivity to pin holes were evaluated as follows :

a) printing endurance : number of printed copies before disappearance of ink in the ink accepting areas begins to occur :

X : 2000 - 5000  0 : more than 5000

b) staining : the number of copies that has to be printed before they are free of background stain when the feeding of paper was started as soon as the inking roll was brought into contact with the surface of the printing plate.

c) sensitivity to pin holes :

0 : no places of lowered density are detected in an area of homogeneous density

# : a few slight places of lowered density are detected in an area of homogeneous density

Table 4

| Printing results | | | | | |
|---|---|---|---|---|---|
| No | Imaging element | Act. | Endurance | Stain | Pin holes |
| 1 | **1** | A | 0 | ~50 | # |
| 2 | **2** | A | X | ~50 | 0 |
| 3 | **3** | A | 0 | ~50 | # |
| 4 | **2** | B | 0 | 0 | 0 |

These results prove that a lithographic plate prepared in accordance with the present invention (No 4) has a good printing endurance, no staining and shows no pin holes.

## Claims

**1.** A method for making a lithographic printing plate according to the silver salt diffusion transfer process comprising the following steps:

- image-wise exposing with a high intensity-short time exposure an imaging element comprising on a support (i) a photosensitive layer comprising silver halide particles substantially free of built-in Iridium, said silver halide particles containing more than 95 mole% of silver chloride and having an average grain diameter of less than 0.27 $\mu$ and (ii) an image receiving layer containing physical development nuclei and
- developing said imaging element using an alkaline processing liquid in the presence of developing agent(s) and a meso-ionic compound.

**2.** A method according to claim 1 wherein said meso-ionic compound is a triazolium thiolate

**3.** A method according to claim 2 wherein said triazolium thiolate corresponds to the following formula:

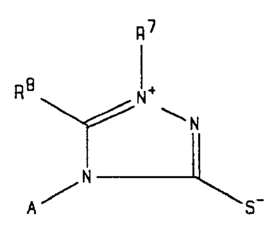

wherein $R^7$ and $R^8$ each independently represents a substituted or unsubstituted alkyl group, a

substituted or unsubstituted alkenyl group, a substituted or unsubstituted cycloalkyl group, a substituted or unsubstituted aralkyl group, a substituted or unsubstituted aryl group or a substituted or unsubstituted heterocyclic group, A represents a substituted or unsubstituted alkyl group, a substituted or unsubstituted alkenyl group, a substituted or unsubstituted cycloalkyl group, a substituted or unsubstituted aralkyl group, a substituted or unsubstituted aryl group, a substituted or unsubstituted heterocyclic group or $-NR^9R^{10}$ and $R^9$ and $R^{10}$ each independently represents hydrogen, a substituted or unsubstituted alkyl group, a substituted or unsubstituted aryl group or $R^7$ and $R^8$ or $R^8$ and A or $R^9$ and $R^{10}$ represent the necessary atoms to form together with the atoms to wich they are attached a 5- or 6-membered ring.

**4.** A method according to any of claims 1 to 3 wherein said meso-ionic compound is present in said alkaline processing liquid.

**5.** A method according to claim 4 wherein said alkaline processing liquid further comprises a silver halide solvent other than said meso-ionic compound.

**6.** A method according to claim 5 wherein said silver halide solvent is a thioether and/or an alkanolamine.

**7.** A method according to any of the claims 1 to 6 wherein said imaging element after the development step is treated with a neutralization solution.

**8.** An imaging element comprising in the order given (i) a support (ii) a photosensitive layer comprising silver halide particles substantially free of built-in Iridium, said silver halide particles containing more than 95 mole% of silver chloride and having an average grain diameter of less than 0.27 $\mu$, (iii) an image receiving layer containing physical development nuclei, said imaging element also comprising a meso-ionic compound.

**9.** An imaging element comprising in the order given (i) a grained and anodized aluminium support and (ii) a photosensitive layer comprising silver halide particles substantially free of built-in Iridium, said silver halide particles containing more than 95 mole% of silver chloride and having an average grain diameter of less than 0.27 $\mu$, said imaging element also comprising a meso-ionic compound.

**10.** An imaging element according to claim 9 comprising between said grained and anodized aluminium support and said photosensitive layer an image receiving layer containing physical development nuclei.

European Patent Office

# EUROPEAN SEARCH REPORT

Application Number
EP 93 20 1761

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| Y | US-A-5 200 294 (R.M. DE KEYZER ET AL.)<br>* column 2, line 14 - line 19; claims; example 1 *<br>* column 3, line 29 - line 56 *<br>* column 5, line 24 - column 6, line 56 *<br>* column 7, line 41 - column 8, line 14 *<br>--- | 1-10 | G03F7/07<br>G03C8/06 |
| D,Y | EP-A-0 449 340 (AGFA-GEVAERT)<br>* page 3, line 4 - line 7 *<br>* page 8, line 15 - line 19 *<br>* page 10, line 16 - line 32 *<br>* page 13, line 32 - line 34; example 3 *<br>--- | 1-10 | |
| Y | EP-A-0 503 164 (AGFA-GEVAERT)<br>* page 5, line 3 - line 15 *<br>* page 9, line 4 - line 11 *<br>* page 10, line 28 - line 29 *<br>* page 11, line 6 - line 8; example 3 *<br>--- | 1-10 | |
| Y | EP-A-0 545 452 (AGFA-GEVAERT)<br>* page 2, line 23 - line 28 *<br>* page 11, line 54 - page 12, line 14 *<br>* page 15, line 7 - line 8 *<br>* page 17, line 13 - line 18; example 1 *<br>* page 19, line 24 - line 27 *<br>--- | 1-10 | TECHNICAL FIELDS SEARCHED (Int.Cl.5)<br>G03F<br>G03C |
| Y | EP-A-0 410 500 (AGFA-GEVAERT)<br>* page 11, line 6 - line 11 *<br>* page 14, line 22 - line 36 *<br>* page 17, line 28 - line 31; example 1 *<br>* page 18, line 42 - line 47 *<br>--- | 1-10 | |
| D,A | EP-A-0 423 399 (AGFA-GEVAERT)<br>* page 4, line 46 - line 57 *<br>* page 9, line 1 - line 9; examples 1-4; table 1 *<br>----- | | |

The present search report has been drawn up for all claims

| Place of search | Date of completion of the search | Examiner |
|---|---|---|
| THE HAGUE | 25 November 1993 | Philosoph, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)